# EUROPÄISCHE PATENTANMELDUNG

(11) **EP 0 917 190 A2**
(43) Veröffentlichungstag der Anmeldung: **19.05.1999**
(21) Anmeldenummer: 98113479.4
(22) Anmeldetag: 20.07.1998
(51) Int. Cl.: H01L 21/60

(54) **Schaltungsträgerplatte**

(30) Priorität: 12.11.1997 DE 19750073
(71) Anmelder: ROBERT BOSCH GMBH, 70442 Stuttgart (DE)
(72) Erfinder: Hauer, Heiner, 70734 Fellbach (DE); Kuke, Albrecht, 71549 Auenwald (DE); Moess, Eberhard, 71540 Murrhardt (DE); Scholz, Werner, 71554 Weissach (DE)

(57) **Zusammenfassung**

Schaltungsträgerplatte (1), auf der ein Bauelement (101) mittels eines Verfahrens aufgelötet ist, das ein automatisches, passives Ausrichten des Bauelements (101) mit Hilfe der Oberflächenspannung flüssigen Lotes (105) bewirkt, welches gleichzeitig zwei korrespondierende Anschlüsse (2, 102) einerseits auf dem Bauelement (101) und andererseits auf der Schaltungsträgerplatte (1) überbrückt. Dabei ist durch Auflagepodeste (20) für den geeigneten Abstand gesorgt.
Der erste Anschluß (2) weist einen Oberflächenteil auf, der in zwei mit Lot (105) benetzbare Teilflächen (3, 4) aufgeteilt ist, von denen die zweite Teilfläche (4) die zentrale erste Teilfläche (3) als geschlossener oder unterbrochener Ring umgibt und sich auf einem zweiten Material befindet, das durch flüssiges Lot (105) gegenüber dem ersten Material, auf dem sich die erste Teilfläche (3) befindet, zögerlicher benetzbar ist. Der durch die Auflagepodeste (20) festgelegte Abstand ist so bemessen, daß das Lot (105) im aufgeschmolzenen Zustand aufgrund seiner Oberflächenspannung eine Anziehungskraft zwischen Bauelement (101) und Schaltungsträgerplatte(1) bewirkt.

## Beschreibung

### Stand der Technik

Die Erfindung geht von der Gattung aus, wie im unabhängigen Anspruch 1 angegeben.
Zur hochpräzisen Montage von elektrischen und optoelektrischen Bauelementen auf Schaltungsträgerplatten ist die sogenannte Flip-Chip-Löttechnik bekannt. Hierbei werden auf korrespondierenden Flächen auf der Schaltungsträgerplatte und auf dem Bauelement lotbenetzbare Anschlüsse (englisch: Pads) erzeugt, die sowohl die mechanische Befestigung als auch die elektrische Kontaktierung ermöglichen. Die Pads sind von einer nicht durch Lot benetzbaren Umrandungsschicht begrenzt. Entweder auf dem Bauelement oder auf der Schaltungsträgerplatte werden auf den Pads sogenannte Lothöcker (engl. Bumps) aufgebracht. Die Bumps werden üblicherweise zunächst in einer Dicke um 20 bis 30 µm entweder in einem Vakuum- oder einem Galvanikprozeß abgeschieden. Dabei werden sie mit Hilfe einer Lackschicht, die etwa die Dicke der erforderlichen Bumphöhe hat, zylinderförmig strukturiert. Bei der galvanischen Abscheidung ist eine sogenannte Underplating-Metallisierung erforderlich, um die elektrische Kontaktierung während des Galvanikprozesses zu gewährleisten. Die dicke Lackschicht und die Underplating-Metallisierung im Bereich außerhalb der Bumps wird entfernt. Die zylinderförmigen Bumps werden aufgeschmolzen und nehmen dabei infolge der Oberflächenspannung des flüssigen Lotes eine kugelabschnittsförmige Gestalt an, die sie beim Erstarren behalten. Die Grundfläche eines aufgeschmolzenen Bumps wird dabei durch dessen Fuß-Pad (engl.: Footprint Pad) definiert, das sich wegen seiner geringeren Dicke mit wesentlich geringeren Toleranzen strukturieren läßt, als die mit einer dicken Lackschicht strukturierten Lotbumps vor dem Aufschmelzen.

Bei der Montage des Bauelementes wird dieses so auf seiner Montagefläche auf der Schaltungsträgerplatte vorpositioniert, daß die Bumps in Kontakt mit den korrespondierenden Pads des Bauelements sind. Beim nachfolgenden Aufschmelzen werden durch die Kräfte der Oberflächenspannung des flüssigen Lotes die Bumps exakt zu den Pads ausgerichtet und laterale Positionierfehler, die beim beim Aufsetzen des Bauelementes entstanden waren, automatisch korrigiert. Die laterale Position des Bauelementes erreicht dadurch nahezu die hochgenaue Lagepräzision der mit einem Maskenprozeß hergestellten Pads auf dem Bauelement bzw. auf der Schaltungsträgerplatte. Gleichzeitig werden über die Bumps auch die elektrischen Verbindungen hergestellt. Dieses nach dem Stand der Technik als "Self-Alignment" bekannte Ausrichtverfahren ist beispielsweise in EP 0 699 931 A1 in den dortigen Fig. 3A bis 3G dargestellt.

Für optoelektronische Bauelemente, insbesondere für Laserdioden ist neben der exakten lateralen Positionierung auch eine ebenso exakte vertikale Postionierung erforderlich, um eine stabile Kopplung zu einer Faser oder einer Abbildungsoptik zu erreichen. Die vertikale Position des mit Bumps montierten Bauelementes ergibt sich als Gleichgewichtszustand zwichen den Oberflächenspannungskräften des flüssigen Lotes und den Gewichtskräften von Lot und Bauelement, wobei die Volumina der einzelnen Bumps, die Padflächen und die Oberflächenbeschaffenheit des flüssigen Lotes und der Padflächen als Parameter eingehen. Diese Größen sind insgesamt nur schwer kontrollierbar, so daß die vertikale Positionierung mit einem wesentlich größeren Fehler behaftet ist als die laterale Positionierung.

Nach dem Stand der Technnik wird versucht, dieses Problem dadurch zu lösen, daß neben den Bumps auf einer der Trägerflächen auf der Schaltungsträgerplatte oder dem Bauelement nicht aufschmelzende Auflagepodeste (englisch: Stand-offs) von definierter Höhe angebracht werden oder indem die Bumps in eine Vertiefung mit definierter Tiefe hineinragen. Nach dem Aufschmelzen und Erstarren der Bumps verringert sich deren Höhe infolge der Formänderung von der Kugelabschnittsform in die Kugelzonenform, sodaß das Bauelement auf den Stand-offs bzw. auf dem Rand der Vertiefung aufsitzt und so eine exakt vordefinierte Höheneinstellung ermöglicht wird. (Siehe EP 0 312 217 A1, IBM Technical Disclosure Bulletin Vol. 16 No. 3 August 1973 S. 767, IBM Technical Disclosure Bulletin Vol. 23 N0. 5 October 1980 S.2156 - 2158, EP 0 248 566 A2)

Nachteilig bei dieser Höheneinstellung ist jedoch, daß beim Benetzen der gegenüberliegenden Konataktfläche durch die Bumps gleichzeitig die laterale Positionskorrektur über die Umrandungsfläche der Pads und die Oberflächenspannung des Lotes sowie die vertikale Positionierung durch Absenken des Bauelementes und Aufsetzen auf die Stand-Offs bzw. auf den Rand der Vertiefung stattfindet. Geschieht nämlich das Aufsetzen des Baulementes bevor die laterale Justagekorrektur vollendet ist, so kann infolge der Haftreibung auf den Stand-Offs bzw. auf dem Rand der Vertiefung keine weitere laterale Bewegung mehr erfolgen, und das Bauelement erreicht nicht die optimale laterale Justageposition. Die Höheneinstellung ist dann zwar verbessert aber die laterale Positionierung ist gegenüber dem oben beschriebenen Verfahren ohne Höhenanschlag verschlechtert. Nach dem Stand der Technik werden daher in den oben zitierten Schriften zusätzliche mechanische Führungen vorgesehen, die während der vertikalen Bewegung die laterale Position definieren. Diese lateralen Führungen lassen sich jedoch nur mit großem Aufwand in der erforderlichen Genauigkeit herstellen. Die laterale Positionierung wird dabei durch die lateralen Führungselemente und nicht durch die einfacher und präziser zu strukturierenden Pads erreicht.

### Vorteile der Erfindung

Die erfindungsgemäße Lösung vermeidet den geschilderten Nachteil und erlaubt selbsttätig sowohl eine optimale laterale als auch eine optimale vertikale Positionierung. Sowohl die laterale als auch die vertikale Positionierung wird durch die erfindungsgemäße Gestaltung bewirkt, so daß keine zusätzlichen lateralen Führungselemente erforderlich sind.

Vorteilhafte Weiterbildungen sind in den abhängigen Ansprüchen angegeben, deren Merkmale auch, soweit sinnvoll, miteinander kombiniert werden können.

### Zeichnung

Das Prinzip der erfindungsgemäßen Lösung wird anhand der Fig. 1 bis 4 erläutert. Ausführungsbeispiele für die technische Realisierung werden in den weiteren Figuren dargestellt.

Im einzelnen ist schematisch dargestellt in
- Figur 1:: eine Seitenansicht einer Schaltungsträgerplatte mit einem darüber gehaltenen Bauelement,
- Figur 2:: dieselbe Seitenansicht nach teilweisem Absenken des Bauelements,
- Figur 3:: dieselbe Seitenansicht nach dem selbsttätigen Ausgleich des lateralen Positionierungsfehlers,
- Figur 4:: dieselbe Seitenansicht der mit dem Bauelement bestückten Schaltungsträgerplatte, bei der das die jeweiligen Anschlüsse miteinander verbindende, noch flüssige oder schon feste Lot zwischen den Anschlüssen äußerlich der Form des Schalltrichters einer Trompete angenähert ist (ähnlich einer Hälfte eines einschaligen Hyperboloids),
- Figur 5:: eine Seitenansicht einer Schaltungsträgerplatte mit einem Anschluß, der für den Bumping-Prozeß vorbereitet ist,
- Figur 6:: eine Seitenansicht einer Schaltungsträgerplatte mit einem Anschluß, der auf eine andere Weise für den Bumping-Prozeß vorbereitet ist,
- Figur 7:: eine Aufsicht auf eine Schaltungsträgerplatte mit einem Anschluß, der eine mögliche Gestalt seiner zweiten, an die zentrale Teilfläche anschließenden Teilfläche (Randfläche) aufweist,
- Figur 8 mit den Teilfiguren a bis h:: einzelne Verfahrensstadien für ein Verfahren zur Herstellung einer Lötverbindung zwischen einem Anschluß auf einer Schaltungsträgerplatte und einem Anschluß auf einem Bauelement,
- Figur 9 mit den Teilfiguren a und b:: zwei Verfahrensstadien für ein Verfahren zur Herstellung einer Lötverbindung zwischen zwei Anschlüssen auf einer Schaltungsträgerplatte und zwei Anschlüssen auf einem elektrooptischen Bauelement,
- Figur 10:: eine Aufsicht auf eine nach Figur 9 hergestellte Schaltungsträgerplatte, die einen Lichtwellenleiter aufweist, der optisch auf das elektrooptische Bauelement ausgerichtet ist.

Im wesentlichen gleiche Teile in unterschiedlichen Figuren sind mit gleichen Bezugszeichen versehen.

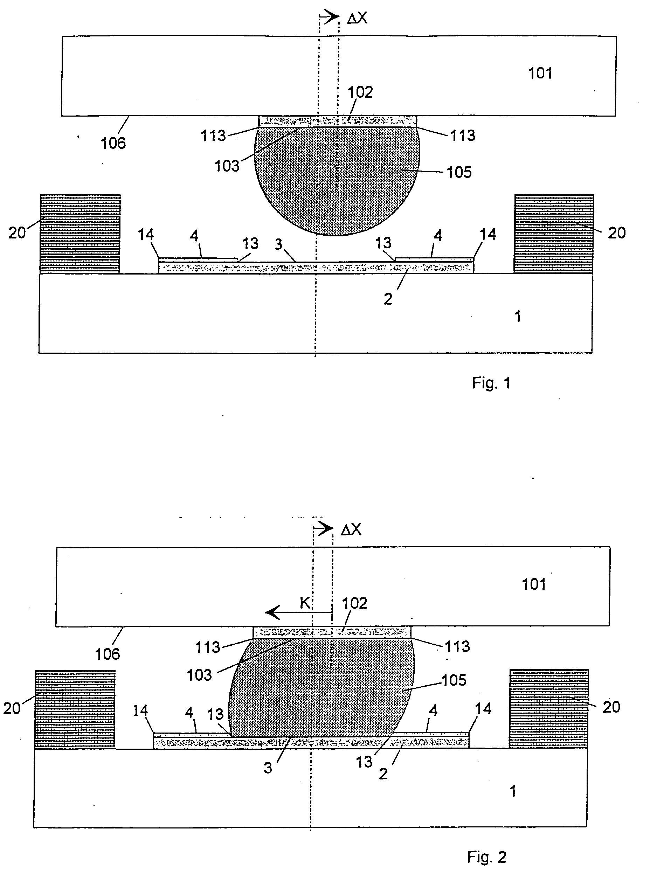

Die Fig. 1 zeigt eine Schaltungsträgerplatte 1 und ein darüber gehaltenes Bauelement 101. Auf der Schaltungsträgerplatte 1 ist eine Anzahl von metallischen Pads 2 und auf dem Bauelement 101 eine gleichgroße Anzahl von metallischen Pads 102 in korrespondierenden Positionen angeordnet. Der Übersichtlichkeit wegen ist jeweils nur ein Pad dargestellt. Infolge eines Positionierungsfehlers des Haltewerkzeugs (nicht eingezeichnet) für das Bauelement 101 sind die Positionen der Padmitten auf der Schaltungsträgerplatte und dem Bauelement um den lateralen Fehler ΔX gegeneinander versetzt. Der Pad 102 hat eine lotbenetzbare Oberfläche 103, die von einer Umrandung 113 umgeben ist, außerhalb derer die Oberfläche 106 des Bauelementes 101 nicht von Lot benetzbar ist. Auf dem Pad 102 sitzt ein kugelabschnittsförmig umgeschmolzener Lotbump 105. Die Position dieses Lotbumps ist durch die Umrandungslinie 113 definiert. Die Umrandung 113 kann, wie nach dem Stand der Technik bekannt, entweder, wie in Fig 1 gezeigt, dadurch erzeugt werden, daß die metallische und lotbenetzbare Schicht an dieser Umrandung endet und die Oberfläche 106 des Bauteils nicht benetzbar ist, oder dadurch, daß eine nicht benetzbare Schicht zunächst auf der Bauelementoberfläche 106 und der Padoberfläche aufgebracht wird und in dieser Schicht im Bereich über dem Pad eine Öffnung strukturiert wird, deren Rand 113 die benetzbare Padfläche 103 begrenzt.

Auf mindestens einem von zwei korrespondierenden Pads, in Fig. 1 ist hierfür der Pad 2 auf der Schaltungsträgerplatte 1 ausgewählt, ist erfindungsgemäß die Padoberfläche in zwei Teilflächen unterteilt. Die zentrale Teilfläche 3 mit einer Umrandungslinie 13 ist dabei sofort von Lot benetzbar und die diese umgebende Randfläche 4 mit der Umrandungslinie 14 ist nur verzögert von Lot benetzbar. Beide Teilflächen 3 und 4 bzw. Umrandungslinien 13 und 14 sind konzentrisch zueinander angeordnet, d. h. ihre Flächenschwerpunkte liegen aufeinander.

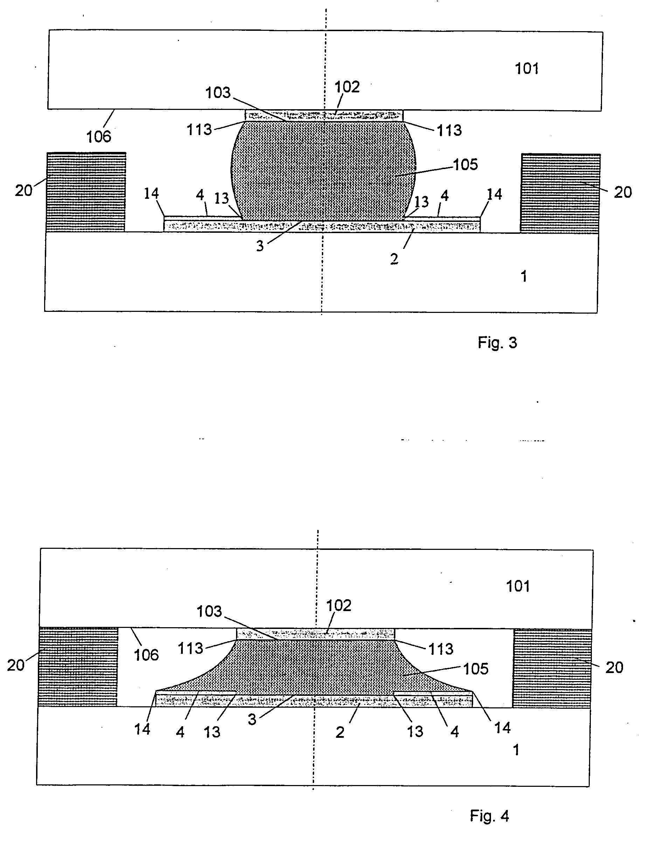

Die Fig. 2 zeigt die Bump-Konfiguration nach dem Aufsetzen des Bumps 105 in die sofort benetzbare zentrale Fläche 3. Das Lot benetzt diese zentrale Fläche und übt wegen der anfänglichen Dejustierung ΔX des Absetzwerkzeuges infolge der Oberflächenspannung eine Querkraft K aus, die den abgesetzten und nun frei beweglichen Chip zentriert. Die zentrierte Position ist in Fig. 3 gezeigt. Nach einer gewissen Zeit ist auch die Randschicht 4 durch das Lot benetzbar, so daß sich das Lot bis zu der Umrandung 14 der Randschicht 4 ausbreiten kann. Da das Lotvolumen konstant bleibt, muß sich die Bumphöhe verringern. Dadurch senkt sich das Bauelement um den Betrag ΔZ ab, bis es auf den Stand-offs 20 aufliegt. Die Höhe dieser Stand-offs definiert die vertikale Position des Bauelementes. Somit ist eine horizontale und vertikale Selbstjustierung ohne gegenseitige Beeinträchtigung in einem Arbeitsprozeß möglich. Als Randbedingung muß beachtet werden, daß die Absenkung ΔZ0 infolge der Basisflächenvergrößerung, die sich ohne Stand-offs einstellen würde, größer ist, als der Weg ΔZ bis zu den Stand-offs. Die Oberflächenspannung des Lotes übt dann noch eine vertikale Zugkraft aus, mit der das Bauelement gegen seine Auflagen gezogen wird, wodurch eine zuverlässige vertikale Positionierung erreicht wird. Beim Erstarren des Lotes während des Abkühlvorganges wird diese Zugkraft sogar noch erhöht, wenn man den Wärmeausdehnungskoeffiezienten der Stand-offs kleiner wählt, als den des Lotes, was für die meisten infrage kommenden Materialien der Fall ist. Die vertikale Zugkraft wird durch die plastische Verformbarkeit des Lotes soweit begrenzt, daß ein Reißen des Lotes oder eine Schädigung des Bauelementes vermieden werden kann. Bei besonders harten Loten, wie zum Beispiel bei Au/Sn-Lot, kann die eingefrorene Zugkraft dadurch begrenzt werden, daß man den Ausdehnungskoeffizienten der Stand-offs nur wenig kleiner als den des Lotes wählt.

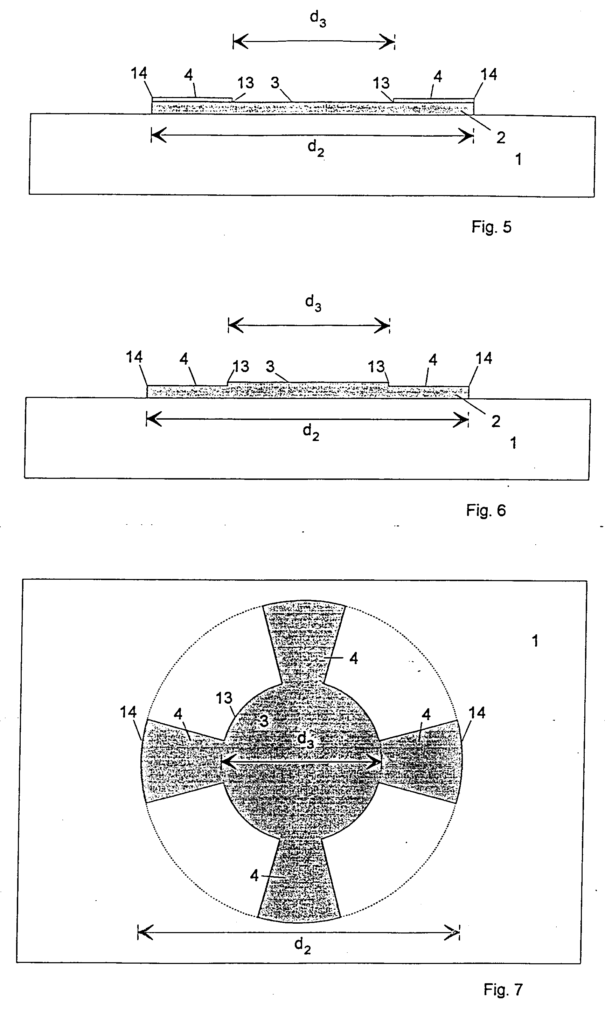

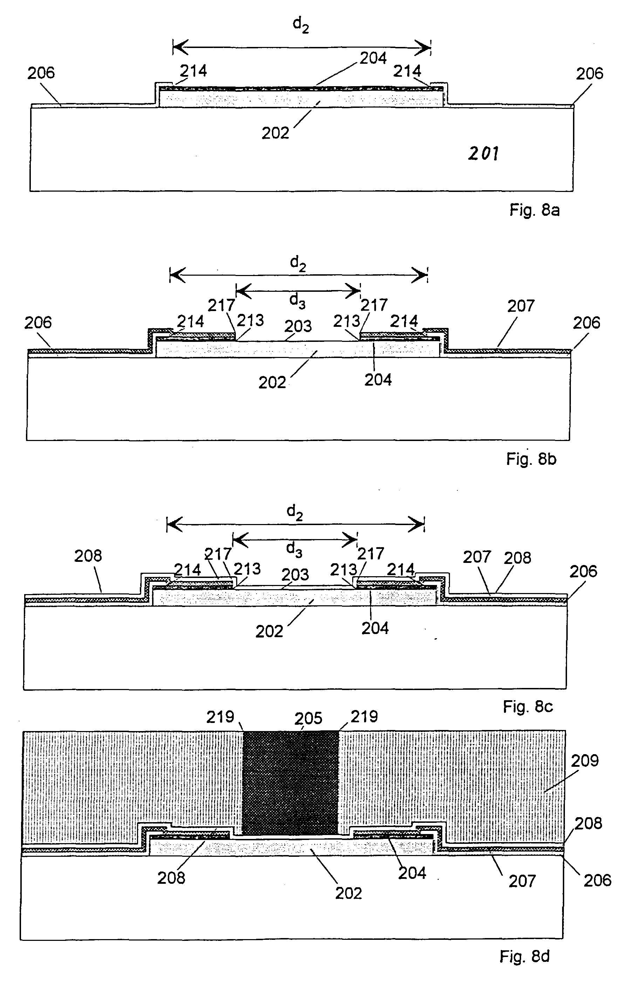

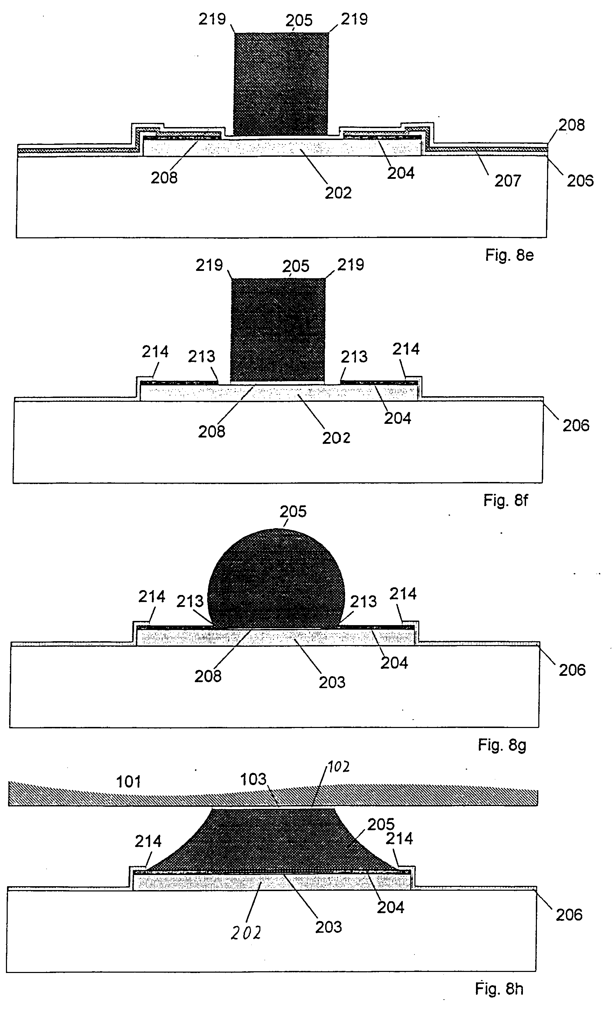

Im folgenden werden einige erfindungsgemäße Vorschläge zur Erzeugung der verzögert benetzbaren Fläche auf dem Randbereich des Pad erläutert. Die Fig. 5 - 7 zeigen die erfindungsgemäße Padstruktur mit verzögert benetzbarer Randfläche jeweils auf der Schaltungsträgerplatte und ohne einem darauf aufgebrachten Bump. Ebenso kann diese Struktur aber auch auf dem Bauelement hergestellt werden oder der Bump kann darüber aufgebaut werden. Nur für den Fall, daß der Bump elektrochemisch über einer durchgehenden Underplating-Metallisierungsschicht abgeschieden wird, müssen die in Fig. 8a - 8h beschriebenen Besonderheiten beachtet werden.

Die Fig. 5 zeigt auf einer Schaltungsträgerplatte 1 eine Goldchicht 2, die fotolithographisch zu einem Pad mit dem Durchmesser d2 strukturiert wurde. Auf dieser Goldschicht wurde eine Nickelschicht 4 abgeschieden, in welche fotolithographisch im mittleren Bereich über der Goldschicht eine Öffnung 3 mit dem Durchmesser d3 strukturiert wurde, so daß dort die Oberfläche der Goldschicht freigelegt wird. Beim Bumping-Prozeß wird ein Lothöcker aus einer Gold-Zinn-Legierung in eutektischer Zusammensetzung verwendet, der mit der Goldschicht innerhalb der Öffnung 3 in Kontakt gebracht wird. Beim Aufschmelzen benetzt das flüssige Lot zunächst nur die freigelegte Au-Schicht bis zur Umrandung 13 der Öffnung 3. Hierbei erfolgt die laterale Selbstjustierung infolge der Oberflächenspannungskräfte des flüssigen Lotes. Bei weiterem Einwirken legiert auch das Nickel mit dem Au/Sn-Lot und wird dabei aufgelöst. Dabei wird auch die Randfläche 4 bis zu deren Umrandung 14 benetzt und dadurch die Bumphöhe erfindungsgemäß reduziert und das Bauelement auf die Stand-offs (hier nicht gezeichnet) abgesenkt. Die zeitliche Verzögerung der Benetzung der Randfläche läßt sich über die Dicke der Nickelschicht einstellen.

Eine Möglichkeit zur Herstellung einer verzögert benetzbaren Randschicht ist in Fig. 6 dargestellt. Hier ist wieder auf einer Schaltungsträgerplatte 1 ein Gold-Pad 2 mit dem Durchmesser d2 aufgebracht. Dieser Goldpad ist in seinem zentralem Bereich 3 mit dem Durchmesser d3 dicker als als in seinem Randbereich 4. Beim Bumping-Prozeß wird der Lotbump zunächst nur mit dem dickeren zentralen Bereich 3 in Berührung gebracht. Dort benetzt das flüssige Lot nach dem Aufschmelzen die Goldoberfläche. Die Erfahrung mit Au/Sn-Lotbumps auf Au-Pads zeigt, daß die Lotbenetzung nur bis zur senkrechten Kante am Rand des Goldpads erfolgt. Infolge der Oberflächenspannung des flüssigen Lotes zum Gold bildet sich ein endlicher dihedrischer Benetzungswinkel des Lotes zur waagerechten Padoberfläche aus. An der senkrechten Kante 13 am Rande des dickeren zentralen Bereiches 3 müßte dieser Winkel auf Null abfallen, was dem Spannungsgleichgewicht der Oberflächenspannungskräfte widerspricht. Dadurch wird eine weitere Benetzung zunächst verhindert. Erst wenn das Gold im dickeren Zentralbereich 3 soweit in das Lot ablegiert ist, daß die senkrechte Stufe an der Kante 13 verschwunden ist, kann das Lot auch die Randzone 4 bis zu deren Rand 14 benetzen. Durch diesen Mechanismus wird die erfindungsgemäß erforderliche Benetzungsverzögerung des Randbereiches erreicht. Die Dauer der Verzögerung läßt sich durch Wahl der Stufenhöhe an der Kante 13 den Erfordernissen entsprechend einstellen.

Eine weitere Möglichkeit zur Verzögerung der Benetzung im Randbereich ist in Fig. 7 in Draufsicht dargestellt. Um einen zentralen Pad-Bereich 3 mit einer unterbrochenen Randlinie 13 sind in einer Randzone sternförmige Ansätze 4 bis zu einer Umrandungslinie 14 angebracht, die vorzugsweise symmetrisch zum Zentrum der Zentralfläche 3 angeordnet sind. Die Zentralfläche und die Randbereiche können hierbei im Unterschied zu den beiden vorigen Vorschlägen aus dem gleichen Material und mit gleicher Dicke hergestellt werden. Die anfänglich im zentralen Bereich 3 beginnende Lotbenetzung wird sich zunächst bis zu deren Randlinie 13 ausbreiten. Wegen der Querschnittsverengung an den Übergängen zu den Randbereichen 4 verzögert sich die Lotbenetzung. Die Zeitdauer der Verzögerung läßt sich über die Geometrie der Ansätze 4 den Erfordernissen der Bumpabsenkung anpassen. Dabei sind auch andere Formen der Ansätze 4 als in Fig 7 gezeigt möglich. Beispielsweise können sich die Ansätze in ihrem Außenbereich auch berühren, so daß inselförmige Aussparungen im Randbereich entstehen oder der Randbereich kann auch gleichmäßig mit Löchern belegt werden.

Die erfindungsgemäße verzögert benetzbare Randschicht kann sowohl auf dem dem Bump gegenüberliegenden und nicht mit einem Bump belegten Pad als auch auf dem Footprint-Pad unter den Bump angebracht werden. Im zweiten Fall muß die Herstellungsweise des Bumps berücksichtigt werden.

Wird der Bump in einem Vakuum-Beschichtungsprozeß aufgebaut, so ist keine Underplating-Metallisierungsschicht erforderlich und es können die drei oben beschriebenen Verzögerungsmechanismen ebenso wie bei einem bumplosen Pad angewandt werden. Dabei ist zu beachten, daß der Bump nur über dem zentralen Teil des Pads aufgebaut wird und sein Durchmesser kleiner oder höchstens gleich groß ist, wie der Durchmesser d3 des zentralen Bereichs. Das gleiche gilt, wenn der Bump durch stromlose Galvanikabscheidung hergestellt wird.

Bei einer Bumpherstellung durch Elektro-Galvanik ist eine Underplating-Metallisierungsschicht erforderlich, damit der Footprint-Pad kathodisch kontaktiert werden kann. Auch für diesen Fall wird eine erfindungsgemäße Lösung zur Herstellung einer verzögert benetzbaren Randschicht auf dem Footprint-Pad vorgeschlagen. Die Arbeitschritte hierfür sind in den Fig. 8a bis 8h dargestellt. Die Darstellung beschreibt den Aufbau eines Bumps auf einer Schaltungsträgerplatte, beispielsweise Silizium. Auf gleiche Weise lassen sich aber auch Bumps auf einem Bauelement herstellen. Der Übersichtlichkeit wegen ist wieder nur die Herstellung eines einzelnen Bumps dargestellt und die Stand-offs (siehe Fig. 1 - 3) wurden nicht gezeichnet.

Die Fig. 8a zeigt eine Schaltungsträgerplatte 201, die aus Silizium oder aber auch aus einem anderen gebräuchlichen Material wie beispielsweise Aluminiumoxid-Keramik bestehen kann. Auf diese Schaltungsträgerplatte wird über einer dem Stand der Technik entsprechenden Haftschicht (hier nicht gezeichnet), eine Kontaktschicht 202 und eine Verzögerungsschicht 204 aufgebracht. Vorzugsweise wird als Material für die Kontaktschicht Gold und für die Verzögerungsschicht Nickel gewählt. Die beiden Schichten 202 und 204 werden gemeinsam photolithographisch strukturiert, so daß ein Footprint-Pad entsteht. Nach der Strukturierung wird eine Lötstopp-Schicht 206 aufgebracht. Diese Schicht kann beim Aufbau auf einer Schaltungsträgerplatte beispielsweise aus Polyimid bestehen. Beim Aufbau des Bumps auf einem Bauelement kann hierzu die ohnehin als Passivierung erforderliche Siliziumnitrid-Schicht dienen. Die Lötstopp-Schicht wird über der Padoberfläche photolithographisch freigeätzt. Dabei entsteht die Umrandung 214, die die Begrenzung der verzögerten Lotbenetzungsfläche 204 mit dem Durchmesser d2 ergibt. Wegen der geringen Dicke der Lötstopp-Schicht läßt sich diese Strukturierung mit sehr hoher Präzision durchführen.

Über diese Strukturen wird eine TiW-Schicht 207 als Haftschicht für eine Underplating-Metallisierungsschicht aufgebracht. Über dem Zentralbereich 203 des Pads wird diese Haftschicht 207 freigeätzt, wobei die Umrandung 217 - 217 entsteht. Innerhalb dieser Umrandung wird auch die Verzögerungsschicht 204 im Zentralbereich 203 des Pads weggeätzt, so daß dort die gut benetzbare Goldschicht freigelgt wird (Fig. 8b). Dieser Zentralbereich 203 mit dem Durchmesser d3 ist von der hochpräzise strukturierbaren Umrandung 213 umgeben, die später die laterale Positionierung des Bumps bewirkt.

Über diese Strukturen wird eine weitere Goldschicht 208 aufgebracht, die als Underplating-Metallisierungsschicht für den Elektro-Galvanikprozeß dient (Fig 8c). Außerhalb des Pad-Zentralbereichs wirkt die TiW-Schicht als Haftschicht für diese Goldschicht 208. Innerhalb der Pad-Zentralbereichs erfolgt die Haftung direkt auf dem Gold in der Zentralzone 203.

Die Strukturen werden nun ganzflächig mit einem dicken Resist 209 beschichtet, der im Bereich 219 - 219 für den dort aufzubauenden Bump frei strukturiert wird. Der freigelegte Bereich 219 - 219 liegt dabei innerhalb der Randlinie 213 - 213 des Zentralbereiches 203 (Fig. 8d). Die dicke Resistschicht 209 läßt sich fotolithographisch nicht so genau strukturieren, wie die dünnen Metall- und Haftschichten. In Fig. 8d ist dies dadurch angedeutet, daß die Öffnung 219 - 219 nicht zentrisch sondern infolge eines lateralen Positionierfehlers etwas versetzt gegenüber der Öffnung 213 - 213 angeordnet ist. Infolge des lateralen Selbstjustierungseffektes wird dieser Versatz im weiteren Prozeß automatisch korrigiert.

Nach dem galvanischen Aufbau der Bumps 205 wird der Galvanik-Resist 209 entfernt (Fig. 8e). Von diesem Prozeßschritt an ist nun eine fotolithographische Strukturierung nicht mehr möglich, da das Aufbringen und Belichten einer Lackmaske wegen der Höhe des Bumps verhindert wird. Die noch erforderlichen Ätzschritte können ganzflächig erfolgen. Die nun freiliegende Goldschicht 208 wird durch ganzflächiges Ätzen entfernt. Bei dieser Goldätzung wird die Nickel-Schicht 204 durch die TiW-Schicht 207 geschützt. Zwischen dem Rand 217 - 217 der TiW-Schicht 207 und dem Rand des Bumps 219 - 219 kann zwar die Goldoberfläche 203 angeätzt werden. Die erste Goldschicht 202 wird aber so dick gewählt, daß ein geringer Abtrag dort unerheblich ist. Unterhalb des Bumps 205 bleibt ein Rest der zweiten Goldschicht 208 über der ersten Godlschicht 202 erhalten. Anschließend wird die TiW-Schicht 207 ganzflächig weggeätzt (Fig. 8f).

Der zylinderförmige Bump wird nun aufgeschmolzen (Fig. 8g), wobei er eine kugelabschnittsförmige Gestalt annimmt. Dabei erfogt die Benetzung zunächst bis zum Rand 213 - 213 der Öffnung in der Nickelschicht 204. Beim Bumping-Prozeß wird das Bauelement 101 mit dem korrespondierenden Gegenpad 103 mit dem aufgeschmolzenen Bump in Kontakt gebracht. Bei weiterer Wärmeeinwirkung wird auch die Nickelschicht 204 auflegiert, so daß die Benetzung bis zum Rand 214 - 214 erfolgt und das Bauelement, wie oben beschrieben, abgesenkt und auf Auflagepodesten (Stand-offs bzw. Rand einer Vertiefung, die die Bumps aufnimmt [hier nicht dargestellt]) abgesetzt wird.

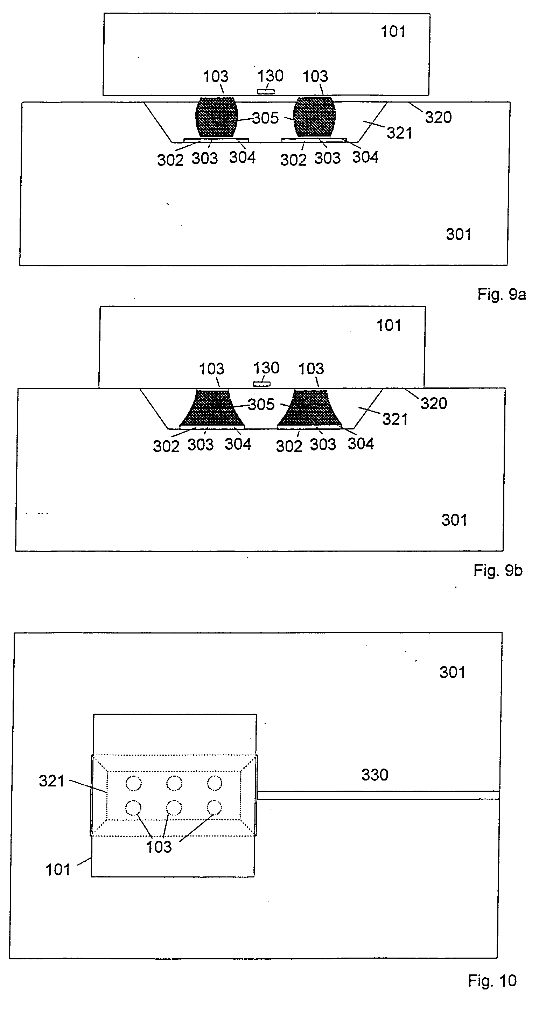

Ein weiteres Ausführungsbeispiel ist in den Fig. 9a, b und 10 gezeigt. Hier wird die erfindungsgemäße laterale und vertikale Positionierung über verzögert benetzbare Pads bei einer Schaltungsträgerplatte 301 mit einer zur Aufnahme der Pads tiefer gelegten Ebene 306 in einer Vertiefung 321 angewandt. Das optoelektronische Bauelement, beispielsweise eine Laserdiode, hat eine Lichtaustrittsfläche 130, die zu einem Lichtwellenleiter 330 auf der Schaltungsträgerplatte 301 auszurichten ist (Fig. 10). Der Lichtwellenleiter kann entweder ein auf dem Schaltungsträger aufgebrachter Streifenwellenleiter oder eine in eine V-Nut eingelegte Faser sein. Die V-Nut kann durch anisotropes Ätzen beispielsweise in einem Silizium-Substrat hergestellt sein. Beim Bumpingprozeß richten die Lotbumps 305 das Bauelement 101 zunächst über die Pad-Flächen 103 und 303 lateral aus (Fig. 9a). Nach Benetzung der verzögert benetzbaren Randfläche 304 wird das Bauelement abgesenkt, bis es auf der Randfläche 320 der Schaltungsträgerplatte 301 aufliegt. Die Randfläche 320 übernimmt hier die Funktion der Stand-offs 20 in Fig. 1 - 3. Die Tiefe der Aussparung 321 muß dabei nicht die Präzision der geforderten vertikalen Endausrichtung besitzen, da diese durch die vertikale Lage der Strahlflächen im Bauelement bzw. im Wellenleiter bestimmt wird. Die Verwendung einer solchen Vertiefung 321 für die vertikale Positionierung ist zwar schon bekannt, doch bringt die gleichzeitige laterale Positionierung über die erfindungsgemäßen verzögerten Benetzungsflächen erst die erforderliche Positionsgenauigkeit auch in lateraler Richtung.

## Patentansprüche

1. Schaltungsträgerplatte, auf der ein Bauelement (101) mit Hilfe eines Verfahrens aufgelötet ist, das ein automatisches, passives Ausrichten des Bauelements (101) auf der Schaltungsträgerplatte (1) mit Hilfe der Oberflächenspannung flüssigen Lotes (105) bewirkt, welches gleichzeitig zwei korrespondierende Anschlüsse (2, 102) überbrückend kontaktiert, von denen sich einer auf dem Bauelement (101) und einer auf der Schaltungsträgerplatte (1) befindet, wobei durch Auflagepodeste (20) zwischen Bauelement (101) und Schaltungsträgerplatte (1) für deren geeigneten Abstand voneinander gesorgt ist,
dadurch gekennzeichnet,
- daß das Lot (105) an der Kontaktfläche, wo es einen Anschluß (2) kontaktiert, eine zentrale Teilzone und wenigstens eine daran anschließende Randzone aufweist,
- daß das Lot (105) in der zentralen Teilzone stärker als in der Randzone mit demjenigen Material legiert ist, das sich an der entsprechenden kontaktierten, zentralen Teilfläche (3) des genannten Anschlusses (2) befindet,
- daß der durch die Auflagepodeste (20) festgelegte Abstand zwischen Bauelement (101) und Schaltungsträgerplatte (1) so bemessen ist, daß das Lot (105) im aufgeschmolzenen Zustand aufgrund seiner Oberflächenspannung eine Anziehungskraft zwischen Bauelement (101) und Schaltungsträgerplatte(1) verursacht.

2. Schaltungsträgerplatte nach Anspruch 1, dadurch gekennzeichnet,
- daß das Lot (105) in der Randzone stärker als in der zentralen Teilzone mit demjenigen anderen Material legiert ist, das sich an der entsprechenden kontaktierten Randfläche (4) des genannten Anschlusses (2) befindet, und
- daß dieses andere Material zögerlicher mit dem geschmolzenen Lot (105) benetzbar ist als das Material, auf dem sich die zentrale Teilfläche (3) befindet.

3. Schaltungsträgerplatte nach Anspruch 1 oder 2,
dadurch gekennzeichnet,
- daß der genannte Anschluß, der im Folgenden als erster Anschluß (2) bezeichnet wird, einen Oberflächenteil aufweist, der dem korrespondierenden zweiten Anschluß (102) gegenüber liegt und der in Teilflächen (3, 4) aufgeteilt ist, von denen wenigstens eine Randfläche (4) an eine zentrale Teilfläche (3) grenzt und gegebenenfalls mit weiteren Randflächen (4 in Figur 7) die zentrale Teilfläche (3) als geschlossener oder unterbrochener Ring umgibt und sich auf einem zweiten Material befindet, das durch flüssiges Lot (105) gegenüber dem ersten Material, auf dem sich die zentrale Teilfläche (3) befindet, zögerlicher benetzbar ist.

4. Schaltungsträgerplatte nach einem der vorangehenden Ansprüche, dadurch gekennzeichnet, daß sich ein Anschluß (2) auf der Schaltungsträgerplatte (1) und ein Anschluß (102) auf dem Bauelement (101) befindet.

5. Schaltungsträgerplatte nach einem der vorangehenden Ansprüche, dadurch gekennzeichnet, daß die Auflagepodeste (20) auf der Schaltungsträgerplatte (1) befestigt sind.

6. Schaltungsträgerplatte nach einem der vorangehenden Ansprüche, dadurch gekennzeichnet, daß der Wärmeausdehnungskoefizient der Auflagepodeste (20) kleiner ist als derjenige des Lote (105)

7. Schaltungsträgerplatte nach einem der vorangehenden Ansprüche, dadurch gekennzeichnet, daß das Material, auf dem sich die zentrale Teilfläche (3) befindet, Gold ist und daß das zweite Material an der Randzone Nickel und das Lot (105) eine Gold-Zinn-Legierung ist.

8. Schaltungsträgerplatte nach einem der vorangehenden Ansprüche, dadurch gekennzeichnet, daß die mit Lot versehene Fläche des Anschlusses (102), welcher der zentralen Teilfläche (3) gegenüber liegt, nicht größer als diese ist.

9. Schaltungsträgerplatte nach Anspruch 8, dadurch gekennzeichnet, daß der mit Lot versehene Anschluß (102), welcher der zentralen Teilfläche (3) gegenüber liegt, kreisförmig ist und einen Durchmesser aufweist, der nicht größer ist als der Durchmesser dieser ebenfalls runden zentralen Teilfläche (3).

10. Schaltungsträgerplatte nach einem der vorangehenden Ansprüche, dadurch gekennzeichnet, daß das Lot (105) zwischen den Anschlüssen der äußeren Form des Schalltrichters einer Trompete angenähert ist.

11. Schaltungsträgerplatte nach einem der vorangehenden Ansprüche, dadurch gekennzeichnet, daß die größere der beiden jeweils einen Anschluß (2, 102) kontaktierenden Flächen des Lotes (105) durch eine Kante (14) am Rand des großflächigeren Anschlusses (2) begrenzt ist.

12. Schaltungsträgerplatte nach einem der vorangehenden Ansprüche, dadurch gekennzeichnet, daß die größere der beiden jeweils einen Anschluß (102, 202) kontaktierenden Flächen des Lotes (205) durch eine Kante (214) einer Lötstoppschicht (206) begrenzt ist.

13. Schaltungsträgerplatte nach Anspruch 12, dadurch gekennzeichnet, daß die Lötstoppschicht (206) aus Polyimid besteht.

14. Schaltungsträgerplatte nach Anspruch 12, dadurch gekennzeichnet, daß die Lötstoppschicht (206) aus Siliziumnitrid besteht.

15. Schaltungsträgerplatte nach einem der vorangehenden Ansprüche, dadurch gekennzeichnet, daß das Bauelement (101) ein optoelektronisches ist.

16. Schaltungsträgerplatte nach einem der vorangehenden Ansprüche, dadurch gekennzeichnet, daß auf der Seite der Schaltungsträgerplatte (301), die dem Bauelement (101) zugewandt ist, ein Lichtwellenleiter (330) angeordnet ist, der auf das Bauelement (101) gerichtet ist.

17. Schaltungsträgerplatte nach einem der vorangehenden Ansprüche, dadurch gekennzeichnet, daß sich an einer Seite der Schaltungsträgerplatte eine Vertiefung (321) befindet, in welcher der erste Anschluß (302) angeordnet ist und deren umlaufende Randstufe (320) als Auflagepodest dient.
